# EUROPÄISCHE PATENTSCHRIFT

(11) **EP 3 724 948 B1**
(45) Veröffentlichungstag und Bekanntmachung des Hinweises auf die Patenterteilung: **02.03.2022**
(21) Anmeldenummer: 18842517.7
(22) Anmeldetag: 11.12.2018
(51) Int. Cl.: H01Q 1/22, H05K 3/32, H05K 1/09, H05K 3/12

(54) **VERFAHREN UND VORRICHTUNG ZUR BESTÜCKUNG EINER ANTENNENSTRUKTUR MIT EINEM ELEKTRONISCHEN BAUELEMENT**
METHOD AND DEVICE FOR EQUIPPING AN ANTENNA STRUCTURE WITH AN ELECTRONIC COMPONENT
PROCÉDÉ ET DISPOSITIF DE MONTAGE D'UNE STRUCTURE D'ANTENNE DOTÉE D'UN COMPOSANT ÉLECTRONIQUE

(30) Priorität: 12.12.2017 DE 102017129625
(43) Veröffentlichungstag der Anmeldung: 21.10.2020
(73) Patentinhaber: Mühlbauer GmbH & Co. KG, 93426 Roding (DE)
(72) Erfinder: NIKLAS, Sigmund, 93199 Zell (DE)
(74) Vertreter: Platzöder, Michael Christian
(86) Internationale Anmeldenummer: PCT/EP2018/084420
(87) Internationale Veröffentlichungsnummer: WO 2019/115557

(56) Entgegenhaltungen:
- EP-A1- 2 418 924
- US-A1- 2006 071 084
- US-A1- 2010 009 071

## Beschreibung

Die vorliegende Erfindung betrifft ein Verfahren sowie eine Vorrichtung zur Bestückung einer Antennenstruktur, insbesondere einer RFID-Antennenstruktur, mit einem elektronischen Bauelement, insbesondere einem RFID-Chip, sowie eine solche mit zumindest einem Bauelement bestückte und elektrisch sowie mechanisch verbundene Antennenstruktur (nachfolgend: Antennenstruktur/Bauelement-Kombination). Dabei steht RFID für Englisch "Radio Frequency Identification" und bezeichnet eine bekannte Technologie für Sender-Empfänger-Systeme zum automatischen und berührungslosen Identifizieren und Lokalisieren von Objekten und Lebewesen mit Radiowellen. Im Falle von RFID kann die mit dem elektronischen Bauelement (RFID-Chip) verbundene Antennenstruktur (Antennenstruktur/Bauelement-Kombination) insbesondere ein sogenanntes RFID-Funketikett, (auch oft als "RFID-Tag" bezeichnet) darstellen oder Teil eines solchen sein. Die Erfindung ist jedoch nicht auf RFID-Applikationen beschränkt, sondern kann ebenso im Zusammenhang mit anderen Technologien und Anwendungen zum Einsatz kommen.

Bekannte Antennenstrukturen können selbsttragend ausgebildet sein, wie etwa herkömmliche Stabantennen aus Metall, oder aber, insbesondere bei Antennen für kurzreichweitige Funkverbindungen, auf einem Trägersubstrat aufgebracht sein, etwa als Dünnschichtmetallisierung. Um ein Funkmodul zu bilden, muss eine Antennenstruktur mit einer entsprechenden Beschaltung versehen werden, die insbesondere in Form eines elektronischen Bauelements in Form eines Funkchips ausgebildet sein kann. Zur Verbindung der Antennenstruktur, bzw. ihres Antennenanschlusses wird bei herkömmlichen Lösungen für auf einem Trägersubstrat aufgebrachten Antennenstrukturen (z.B. für RFID-Tags) typischerweise ein elektrisch leitfähiger Klebstoff, z. B. auf Epoxidbasis, auf einen Antennenanschluss der Antennenstruktur aufgebracht und sodann das elektronische Bauelement darauf platziert. Zudem werden zur anschließenden thermischen Aushärtung des Klebstoffs typischerweise beheizte Thermoden eingesetzt, um das Bauelement während des Aushärtens auf den Antennenanschluss drücken und den Klebstoff zu erwärmen.

Die Druckschrift US 2006/0071084 A1 offenbart ein Verfahren zur Herstellung kostengünstiger RFID-Bauelemente, wobei ein Muster aus metallischem Toner auf ein Substrat gedruckt wird und die Kontakte auf einem Siliziumchip direkt auf Kontaktpunkte gesetzt werden, die als Teil des Musters des Metalltoners gedruckt werden. Das ganze Bauelement wird dann erhitzt, um sowohl den Metalltoner mittels Härtung in metallische Leiter umzubilden als auch den Siliziumchip mit den metallischen Leitern zu verbinden.

Der vorliegenden Erfindung liegt die Aufgabe zugrunde, ein Verfahren sowie eine Vorrichtung zur verbesserten Bestückung einer Antennenstruktur, insbesondere einer RFID-Antennenstruktur, mit einem elektronischen Bauelement, insbesondere einem RFID-Chip, sowie eine entsprechende Antennenstruktur/Bauelement-Kombination anzugeben.

Eine Lösung dieser Aufgabe wird gemäß der Lehre der unabhängigen Ansprüche erreicht. Verschiedene Ausführungsformen und Weiterbildungen der Erfindung sind Gegenstand der Unteransprüche.

Ein erster Aspekt der Erfindung betrifft ein Verfahren gemäß Anspruch 1 zur Bestückung einer Antennenstruktur, insbesondere einer RFID Antennenstruktur, mit einem elektronischen Bauelement, insbesondere einem RFID-Chip. Das Verfahren kann auch eingesetzt werden, um die Antennenstruktur mit mehreren elektronischen Bauelemente zu bestücken.

Unter einer "Antennenstruktur" ist im Sinne der Erfindung eine räumlich-körperliche Struktur aus elektrisch leitfähigem Material, insbesondere einem Metall oder einer Metalllegierung, zu verstehen, die als Funkantenne ausgebildet ist. Die Antennenstruktur kann insbesondere auf einem Trägersubstrat, etwa aus Papier oder Kunststoff ausgebildet sein, insbesondere auch als Dünnschicht.

Unter einem "elektronischen Bauelement" ist im Sinne der Erfindung (i) ein elektronisches passives oder aktives Einzelbauelement, (ii) eine elektronische Schaltung, insbesondere eine integrierte Schaltung (IC), oder (iii) eine Baugruppe, etwa eine gedruckte Schaltung (engl. PCB, Printed Circuit Board), welche mehrere Einzelbauelemente oder elektronische Schaltungen aufweist, zu verstehen. Ein Anschluss des Bauelements kann somit insbesondere ein elektrisch leitendes Anschlusspad bzw. eine elektrisch leitende Kontaktfläche auf einem Einzelbauelement, einer integrierten Schaltung oder einer Baugruppe sein.

Unter einem "sinterfähigen und nach seiner Sinterung elektrisch leitfähigen Material" ist ein Werkstoff zu verstehen, der feinkörnige elektrisch leitfähige, insbesondere metallische, Partikel enthält, und der bei Erhitzung auf eine (Sinter-)Temperatur, die jedoch unterhalb der Schmelztemperatur der Hauptkomponenten des Werkstoffs bleibt, so dass die Gestalt (Form) des Werkstückes (hier der Antennenstruktur) erhalten bleibt, seine endgültigen Eigenschaften, wie etwa Härte, Festigkeit oder elektrische Leitfähigkeit und/oder Temperaturleitfähigkeit erhält ohne dass dafür eine Ausübung von Druck auf den Werkstoff erforderlich wäre. Insbesondere kann der Werkstoff vor der Sinterung ein elektrischer Isolator sein oder nur eine gegenüber seiner elektrischen Leitfähigkeit nach dem Sintern geringere elektrische Leitfähigkeit aufweisen, so dass die endgültige elektrische Leitfähigkeit der fertigen Antennenstruktur erst durch die Sinterung bewirkt wird.

Mithilfe des Verfahrens ist es insbesondere möglich, den Herstellungsprozess für die Antennenstruktur/Bauteil-Kombination zu vereinfachen, was unter anderem zur Erreichung von Zeit- und Kosteneinsparungen genutzt werden kann. So können gegenüber einem herkömmlichen Fertigungsprozess insbesondere einzelne Fertigungsschritte vereinfacht werden oder gar wegfallen. Insbesondere ist zur endgültigen Herstellung der Verbindung zwischen der Antennenstruktur und dem Bauelement die Verwendung von beheizten Thermoden nicht mehr erforderlich, was zudem die damit zusammenhängende Gefahr von mechanischen Beschädigungen des Bauelements eliminiert. Auch entfällt so der bisherige Fertigungsschritt zum Aufbringen von Klebstoff zur Fixierung des Bauelements an der Antennenstruktur.

Da bei dem Verfahren vor dem Aufbringen des Bauelements die Antennenstruktur zunächst mittels Aufdrucken der Antennenstruktur auf das Trägersubstrat mit einer sinterfähigen Tinte erzeugt wird, welche elektrisch leitfähige Partikel zur Ausbildung einer elektrischen Leitfähigkeit der durch das nachfolgende Erwärmen gesinterten Antennenstruktur enthält, ist es zudem auf einfache und hochflexible Weise möglich, verschiedenste Antennenstrukturen auf einem entsprechenden Trägersubstrat auszubilden, ohne dass diese vorher vorgefertigt werden müssen.

Der Heizschritt zum Erwärmen der Tinte im Bereich der Berührungsfläche auf eine unterhalb der Sintertemperatur der Tinte liegende Temperatur zur vorläufigen klebstofflosen mechanischen Verbindung des Bauelements mit der Antennenstruktur wird dagegen, wie schon erwähnt, zur vorläufigen klebstofflosen mechanischen Verbindung des Bauelements mit der Antennenstruktur eingesetzt.

Die vorläufige mechanische Verbindung wird dabei insbesondere durch weitere Trocknung der Tinte bewirkt, sodass sich dabei an dessen mit der Tinte benetzten Oberflächenbereich (d.h. an der Berührungsfläche) eine zumindest schwache Haftung des Bauelements auf der Antennenstruktur ergibt.

Als "Sintertemperatur" ist hier eine Temperatur zu verstehen, oberhalb derer die Sinterung der Tinte (bei ansonsten Normalbedingungen) schon allein temperaturbedingt (also insbesondere auch ohne Druckbeaufschlagung) einsetzt. Insbesondere stellt die im Verfahren tatsächlich zur Sinterung eingesetzte Temperatur eine Sintertemperatur im Sinne der Erfindung dar.

Nachfolgend werden bevorzugte Ausführungsformen und Weiterbildungen des Verfahrens beschrieben, die jeweils, soweit dies nicht ausdrücklich ausgeschlossen wird, beliebig miteinander sowie mit den im Weiteren beschriebenen anderen Aspekten der Erfindung kombiniert werden können. Insbesondere ist das Verfahren geeignet, eine Antennenstruktur/Bauelement-Kombination gemäß dem im Weiteren beschriebenen dritten Aspekt der vorliegenden Erfindung herzustellen.

Gemäß bevorzugter Ausführungsformen weist das Verfahren des Weiteren auf: vor dem Aufbringen des Bauelements, Erwärmen der ausgebildeten Antennenstruktur auf eine unterhalb der Sintertemperatur des sinterfähigen Materials liegende Temperatur zur zumindest teilweisen Trocknung des sinterfähigen Materials und/oder des Trägersubstrats. Dieser Heizschritt zur zumindest teilweisen Trocknung der Tinte und/oder des Trägersubstrats vor dem Aufbringen des Bauelements kann insbesondere dazu dienen, die Tinte bzw. das Trägersubstrat nach dem Aufbringen der Tinte auf das Trägersubstrat so weit zu trocknen, dass beim nachfolgenden Aufbringen des elektronischen Bauelements auf die gedruckte Antennenstruktur dadurch keine unerwünschten Formänderungen der Antennenstruktur, beispielsweise durch Verwischen oder Verdrängen von noch flüssiger Tinte oder unerwünschte Verformungen des noch feuchten Trägersubstrats bewirkt werden.

Gemäß weiterer bevorzugter Ausführungsformen dazu enthält die Tinte des Weiteren ein Antioxidansmittel (Reduktionsmittel). Dadurch können insbesondere die leitfähigen Partikel in der Tinte vor Materialveränderungen aufgrund von Oxidation geschützt werden. Bei einer bevorzugten Ausführung enthält eine solche Tinte metallische Nanopartikel (zum Beispiel aus Kupfer), ein Trägermittel (beispielsweise Di(propylenglycol)-Methyl-Äther) sowie ein solches Antioxidansmittel (beispielsweise Butylhydroxytoluol (BHT), Ascorbinsäure oder Alkanthiole). Ein besonders geeignetes Mischungsverhältnis liegt dabei, auf das Volumen (100%) der Tinte bezogen, bei ca. 25-35% Nanopartikel, ca. 65-75 % Trägermittel und < 1% Antioxidansmittel. Besonders bevorzugt ist dabei ein Mischungsverhältnis von ca. 30% Nanopartikel, ca. 70 % Trägermittel und < 1% Antioxidansmittel.

Gemäß weiterer bevorzugter Ausführungsformen erfolgt das Aufdrucken der Antennenstruktur auf das Trägersubstrat mittels eines Tintenstrahldruckers. Dies ermöglicht eine besonders hohe Flexibilität bzw. Variabilität bezüglich der Erzeugung unterschiedlichster Antennenstrukturformen, da anders, als etwa beim klassischen Siebdruck, weder eine vorgefertigte Druckmaske hergestellt werden muss noch ein Austausch derselben zur Herstellung verschiedener Antennenstrukturformen erforderlich ist. Dies kann neben der Erreichung einer entsprechend erhöhten Flexibilität insbesondere auch zur Senkung von Prozessierungszeiten und dementsprechend auch von Herstellungskosten verwendet werden.

Gemäß weiterer bevorzugter Ausführungsformen wird beim Erwärmen der Antennenstruktur zum Sintern derselben die Antennenstruktur zumindest im Bereich der Berührungsfläche auf eine Temperatur (Sintertemperatur) von mindestens 250 °C, bevorzugt von mindestens 300 °C erhitzt. Vorzugsweise wird dabei eine Temperatur von 350 °C nicht überschritten. Es hat sich herausgestellt, dass dieser Temperaturbereich besonders geeignet ist, zum einen eine Sinterung der Tinte herbeizuführen und zum anderen die temperaturbedingte Belastung des elektronischen Bauelements sowie des Trägersubstrats mit der Antennenstruktur möglichst gering zu halten und dadurch bedingte Beeinträchtigungen oder Beschädigungen zu vermeiden.

Gemäß weiterer Ausführungsformen erfolgt das Aufbringen des Bauelements auf die Antennenstruktur entweder durch (i) unmittelbares Übertragen des Bauelements von einem Bauteilträgersubstrat auf die Antennenstruktur (z.B. per DDA, engl. *direct die attachment*); oder durch (ii) mittelbares Übertragen des Bauelements von einem Bauteilträgersubstrat auf die Antennenstruktur mittels einer Übertragungseinrichtung, die das Bauelement von dem Bauteilträgersubstrat, etwa einem Halbleiterwafer oder einem Komponententräger (z.B. Band (*tape*) oder Tablet (*tray*)), übernimmt, zur Antennenstruktur transportiert, und auf diese aufbringt. Während die Ausführungsform (i) insbesondere Kosten und Geschwindigkeitsvorteile liefern kann, ist die Ausführungsform (ii) insbesondere dann vorteilhaft einsetzbar, wenn nicht nur eine einzige Art von Komponenten verarbeitet werden soll, oder wenn die Breite des Trägersubstrats die effektive Breite des Bauelementeträgers überschreitet, sodass eine unmittelbare Übertragung nur erschwert oder gar nicht möglich wäre.

Gemäß weitere Ausführungsformen erfolgt bei dem Verfahren des Weiteren ein Einhäusen des elektronischen Bauelements nach Herstellung von dessen mechanischer und elektrischer Verbindung mit der Antennenstruktur. Auf diese Weise wird das Bauelement mittels des Gehäuses vor unerwünschten externen Einflüssen geschützt. Auch kann auf diese Weise die mechanische Stabilität der entstandenen Antennenstruktur/Bauelement-Kombination erhöht werden. Gemäß einer bevorzugten Variante dazu, erfolgt das Einhäusen kontaktlos mittels Aufbringen einer flüssigen oder pastösen Gehäusemasse auf das Bauteil und anschließendes Aushärten derselben. Insbesondere kann so das ein Einhäusen mittels der aus der Herstellung von Halbleiterbauelementen bekannten Globe-Top-Technologie erfolgen, bei der eine flüssige oder pastöse Gehäusemasse auf das Halbleiterbauelement (Chip, Bare Die) aufgebracht und anschließend thermisch oder bevorzugt mittels Bestrahlung mit ultravioletten Licht ausgehärtet wird.

Gemäß weiterer Ausführungsformen erfolgt bei dem Verfahren des Weiteren ein sensorisches Inspizieren der Antennenstruktur und/oder des Bauteils zu zumindest einem Zeitpunkt während des Ablaufs des Verfahrens. Der weitere Verfahrensablauf wird sodann in Abhängigkeit vom Ergebnis dieser sensorischen Inspektion gesteuert. So kann der weitere Verfahrensablauf, insbesondere auch der Einsatz von Ausgangskomponenten, wie etwa dem Material der Antennenstruktur, der elektronischen Bauelemente, und/oder der Gehäusemasse im Falle des Einhäusens, in Abhängigkeit davon zu steuern, ob bei einem vorausgehenden Verfahrensschritt ein Produktionsfehler aufgetreten ist, der die Herstellung eines fehlerfreien Produkts (Antennenstruktur/Bauelemente-Kombination) auf Basis der inspizierten, gegebenenfalls schon bestückten, Antennenstruktur nicht mehr erwarten lässt. Auf diese Weise wird es insbesondere ermöglicht, Produktionsfehler zu erkennen und entsprechende fehlerhafte Produktionsergebnisse auszuschleusen, den Materialeinsatz zu optimieren, und Durchlaufzeiten zu optimieren.

Insbesondere kann gemäß einer speziellen Ausführungsform dazu das Verfahren so definiert sein, dass wenn gemäß dem Ergebnis der Inspektion ein Produktionsfehler erkannt wurde, der weitere Verfahrensverlauf so gesteuert wird, das dabei zumindest ein Verfahrensschritt des Verfahrens, der zur Herstellung einer fehlerfreien Antennenstruktur-Bauelement-Kombination verfahrensgemäß vorgesehen ist, ausgelassen wird. Beispielsweise kann das Aufbringen des elektronischen Bauelements auf die Antennenstruktur ausgelassen werden, wenn mittels der Inspektion zuvor erkannt wurde, dass die Antennenstruktur fehlerhaft ist. Auf ähnliche Weise können auch einer oder mehrere dem Aufbringen des Bauelements nachfolgende Prozessschritte unterlassen werden. Beispielsweise kann das Einhäusen entfallen, wenn bei der Inspektion festgestellt wurde, dass das auf die Antennenstruktur aufgebrachte Bauelement fehlerhaft ist.

Gemäß weiterer Ausführungsformen ist das Trägersubstrat bandförmig ausgebildet und wird entlang seiner Längsrichtung transportiert. Entlang einer zu der Längsrichtung in einem Winkel verlaufenden zweiten Richtung auf dem Trägersubstrat werden eine Mehrzahl von Antennenstrukturen vorgesehen bzw. erzeugt, so dass sich entlang der Transportrichtung ein mehrspuriger Herstellungs- bzw. Bestückungsprozess zur Herstellung einer entsprechend auf mehreren Spuren verteilten Menge an Antennenstruktur/Bauteil-Kombinationen ergibt. Auf diese Weise ist es möglich, bei zumindest einem, bevorzugt jedem, Verfahrensschritt parallel eine Mehrzahl von Antennenstrukturen bzw. Antennenstruktur/Bauelement-Kombinationen zu prozessieren, was insbesondere zu einer Effizienzerhöhung gegenüber einem Prozess mit rein serieller Prozessierung genutzt werden kann.

Ein zweiter Aspekt der Erfindung betrifft eine Vorrichtung zur Bestückung einer Antennenstruktur, insbesondere einer RFID Antennenstruktur, mit einem elektronischen Bauelement, insbesondere einem RFID-Chip, wobei die Vorrichtung eingerichtet ist, das Verfahren gemäß dem ersten Aspekt der Erfindung, bevorzugt gemäß einer oder mehrere seiner hierin beschriebenen Ausführungsformen, auszuführen. Das vorausgehend jeweils für das Verfahren Gesagte trifft somit entsprechend auch auf die Vorrichtung zu.

Gemäß einiger Ausführungsformen weist die Vorrichtung eine Bestückungseinrichtung und eine Sintereinrichtung auf. Die Bestückungseinrichtung ist konfiguriert, ein elektronisches Bauelement auf eine auf einem Trägersubstrat ausgebildete Antennenstruktur aus einem sinterfähigen und nach seiner Sinterung elektrisch leitfähigen Material so aufzubringen, dass sich dabei eine Berührungsfläche zwischen einem Anschlussbereich der Antennenstruktur und einem entsprechenden elektrischen Anschluss des Bauelements ausbildet. Die Sintereinrichtung ist konfiguriert, die Antennenstruktur zum Sintern derselben bei gleichzeitiger dadurch bewirkter Ausbildung einer klebstofflosen mechanischen und elektrischen Verbindung zwischen dem Anschlussbereich der Antennenstruktur und dem elektrischen Anschluss des Bauelements zu erwärmen.

Gemäß verschiedener Ausführungsformen, weist die Bestückungseinrichtung eine erste Übertragungseinrichtung, die zum unmittelbaren Übertragen eines Bauelements von einem Trägersubstrat auf die Antennenstruktur konfiguriert ist, und/oder eine zweite Übertragungseinrichtung, die zum mittelbaren Übertragen eines Bauelements von einem Trägersubstrat auf die Antennenstruktur konfiguriert ist, auf. Dabei ist die zweite Übertragungseinrichtung, falls vorhanden,ddd wiederum konfiguriert, das Bauelement von einem Trägersubstrat zu übernehmen, zur Antennenstruktur zu transportieren, und es auf diese aufzubringen.

Gemäß weiterer Ausführungsformen weist die Vorrichtung des Weiteren eine oder mehrere der folgenden Einrichtungen auf: (i) eine Druckeinrichtung, die konfiguriert ist zum Erzeugen der Antennenstruktur, vor dem Aufbringen des Bauelements, mittels Aufdrucken der Antennenstruktur auf das Trägersubstrat mittels einer sinterfähigen Tinte, welche elektrisch leitfähige Partikel, insbesondere Nanopartikel, zur Ausbildung einer elektrischen Leitfähigkeit der Antennenstruktur durch Sintern mittels der Sintereinrichtung enthält; (ii) eine Trockeneinrichtung, die konfiguriert ist zum Erwärmen der erzeugten Antennenstruktur auf eine unterhalb der Sintertemperatur des Materials der Antennenstruktur liegenden Temperatur zur zumindest teilweisen Trocknung der Tinte und/oder des Trägersubstrats vor dem Aufbringen des Bauelements; (iii) eine Fixierungseinrichtung, die konfiguriert ist, die Tinte im Bereich der Berührungsfläche auf eine unterhalb der Sintertemperatur der Tinte liegende Temperatur zur vorläufigen klebstofflosen mechanischen Verbindung des Bauelements mit der Antennenstruktur zu erwärmen; (iv) eine Einhäusungseinrichtung, die konfiguriert ist zum Einhäusen des elektronischen Bauelements nach Herstellung von dessen mechanischer und elektrischer Verbindung mit der Antennenstruktur; (v) eine Sensoreinrichtung zum sensorischen Inspizieren der Antennenstruktur und/oder des Bauteils zu zumindest einem Zeitpunkt während des Ablaufs des Verfahrens, sowie eine Steuerungseinrichtung zum Steuern oder Regeln des Weiteren Verfahrensablaufs in Abhängigkeit von Ergebnis dieser sensorischen Inspektion; (iv) eine Puffereinrichtung, die konfiguriert ist zum Puffern des Trägersubstrats zwischen zwei aufeinanderfolgenden der Einrichtungen der Vorrichtung; (vii) eine Prüfeinrichtung zum Testen der fertiggestellten Antennenstruktur/Bauteil-Kombination; (viii) eine Vereinzelungseinrichtung zum Vereinzeln der auf einem gemeinsamen Trägersubstrat hergestellten Antennenstruktur/Bauelement-Kombinationen.

Unter "konfiguriert" ist im Sinne der Erfindung zu verstehen, dass die entsprechende Vorrichtung bzw. Einrichtung bereits eingerichtet ist oder einstellbar - d.h. konfigurierbar - ist, eine bestimmte Funktion zu erfüllen. Die Konfiguration kann dabei beispielsweise über eine entsprechende Einstellung von Parametern eines Prozessablaufs oder von Schaltern oder ähnlichem zur Aktivierung bzw. Deaktivierung von Funktionalitäten bzw. Einstellungen erfolgen. Insbesondere kann die Vorrichtung mehrere vorbestimmte Konfigurationen oder Betriebsmodi aufweisen, so dass das Konfigurieren mittels einer Auswahl einer dieser Konfigurationen bzw. Betriebsmodi erfolgen kann.

Die Trockeneinrichtung, die Fixierungseinrichtung sowie die Sintereinrichtung sind demnach jeweils zur Erwärmung der Antennenstruktur bzw. der Antennenstruktur/Bauelement-Kombination vorgesehen, so dass zumindest zwei oder mehr dieser Einrichtungen auch als Baueinheit ausgeführt sein können, etwa um unter Verwendung von Dual-Use-Komponenten eine besonders effiziente oder raumoptimierte Lösung implementieren zu können.

Mittels des Verfahrens gemäß dem ersten Aspekt der Erfindung und/ oder einer Vorrichtung gemäß dem zweiten Aspekt der Erfindung ist eine Antennenstruktur, insbesondere RFID-Antennenstruktur, mit einem damit verbundenen elektronischen Bauelement, insbesondere einem RFID-Chip herstellbar. Die Antennenstruktur ist auf einem Trägersubstrat ausgebildet und aus einem gesinterten elektrisch leitfähigen Material gefertigt. Sie ist an einer Berührungsfläche zwischen einem Anschlussbereich der Antennenstruktur und einem entsprechenden elektrischen Anschluss eines elektronischen Bauelements mittels einer klebstofflosen, mittels des gesinterten Materials ausgebildeten mechanischen und elektrischen Verbindung mit dem Bauelement verbunden.

Weitere Vorteile, Merkmale und Anwendungsmöglichkeiten der vorliegenden Erfindung ergeben sich aus der nachfolgenden detaillierten Beschreibung im Zusammenhang mit den Figuren.

Dabei zeigt
Fig. 1 schematisch ein Flussdiagramm zur Veranschaulichung einer bevorzugten Ausführungsform des erfindungsgemäßen Verfahrens;
Fig. 2 schematisch verschiedene Zwischenzustände einer zu fertigenden Antennenstruktur/Bauelement-Kombination, die bei ihrer Herstellung gemäß dem Verfahren aus Fig. 1 auftreten; und
**Fig. 3** ein Blockdiagramm zur Illustration einer bevorzugten Ausführungsform der erfindungsgemäßen Vorrichtung;

In den nachfolgenden Figuren, werden durchgängig dieselben Bezugszeichen für dieselben oder einander entsprechende Elemente der Erfindung verwendet.

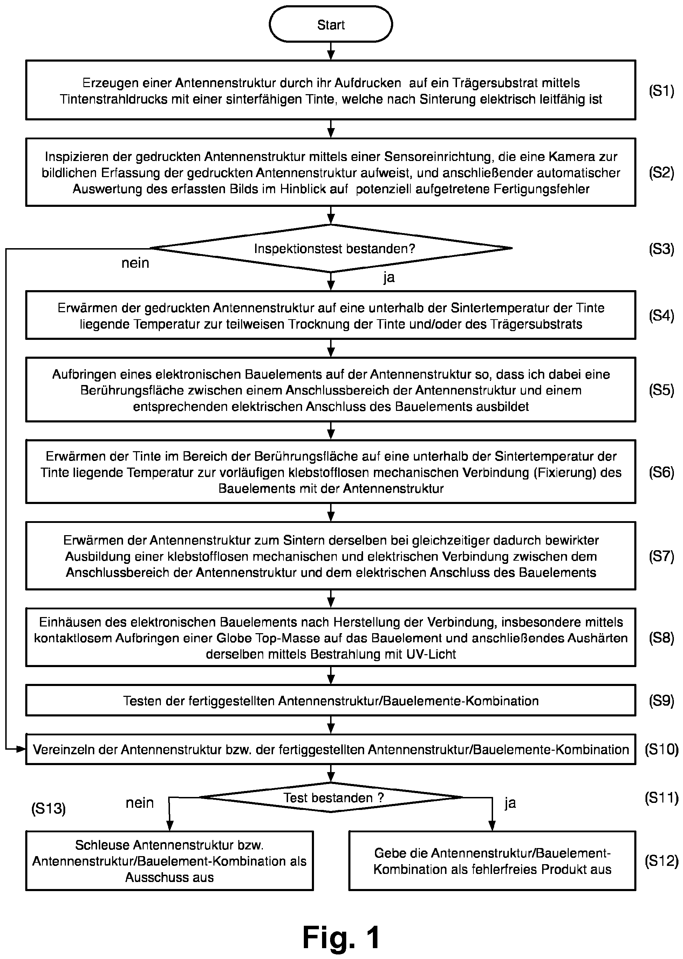

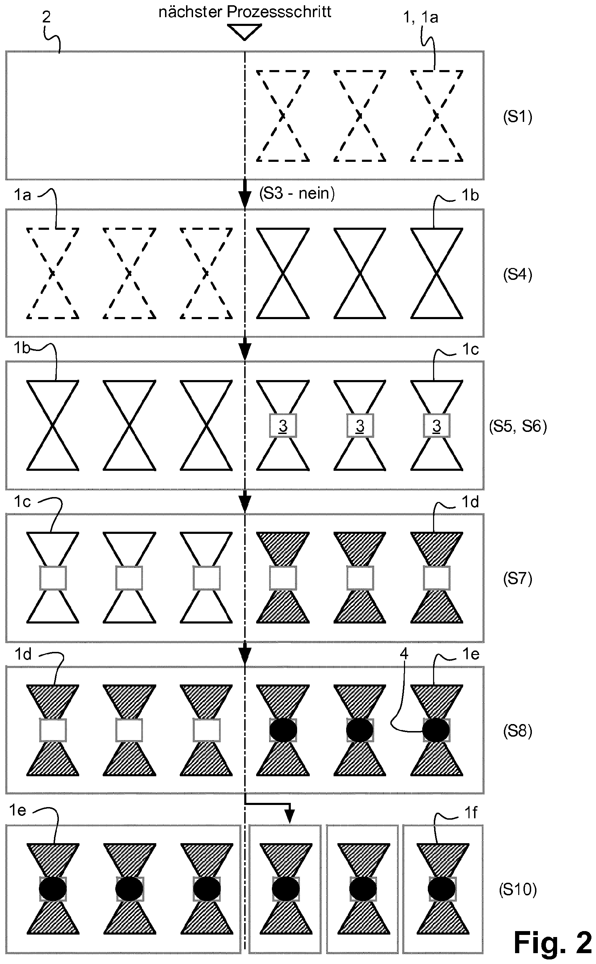

Zunächst wird unter Bezugnahme auf die Figuren **Fig. 1** **und** **2** eine bevorzugte Ausführungsform des erfindungsgemäßen Verfahrens bzw. Prozesses erläutert. Das Verfahren weist einen Schritt S1 auf, bei dem eine Antennenstruktur 1 bzw. 1a durch Aufdrucken auf ein Trägersubstrat 2 erzeugt wird. Zum Drucken wird dabei vorzugsweise ein Tintenstrahldrucker eingesetzt. Als Tinte wird eine sinterfähige Tinte verwendet, die jedenfalls nach ihrer Sinterung elektrisch leitfähig ist. Die Tinte enthält dazu vorzugsweise neben einem flüssigen oder pastösen Trägermittel metallische Nanopartikel, beispielsweise aus Kupfer, sowie bevorzugt noch ein Antioxidansmittel (Reduktionsmittel) als Korrosionsschutz für die Nanopartikel. In Fig. 2 ist das Trägersubstrat als Band ausgebildet, auf dem entlang seiner Längserstreckung bzw. - richtung eine Reihe (Spur) von Antennenstruktur/Bauelement-Kombinationen erzeugt wird (einspuriges Verfahren). Alternativ dazu können auf dem Trägersubstrat auch in einer in einem Winkel, insbesondere senkrecht, zur Längsrichtung stehenden Richtung in einer oder mehreren Spuren weitere Antennenstrukturen erzeugt werden, so dass sich insgesamt ein mehrspuriger und in diesem Sinne parallelisierter Prozess ergibt.

Beim mehrspurigen Herstellungs- bzw. Bestückungsprozess kann zumindest eine der folgenden Einrichtungen in Längsrichtung und/oder in der zu der Längsrichtung in einem Winkel verlaufenden zweiten Richtung motorisch verschiebbar sein, um mit einer Einrichtung mehrere Reihen zu bearbeiten: Drucker 11, Kamera 2, Einhäusungseinrichtung 17 und Prüfeinrichtung 18. Die Trockeneinrichtung 13a, b, die Fixierungseinrichtung 15 und die Sintereinrichtung 16a, b können für den mehrspurigen Prozess insbesondere durch eine entsprechend breite, mehrere Spuren abdeckende Bauform angepasst sein. Der Begriff "Richtung" umfasst hier jeweils auch die entsprechende Gegenrichtung, so dass die motorische Verschiebung beispielsweise sowohl entlang der Transportrichtung des Trägersubstrats als auch in entgegengesetzter Richtung, d.h. entgegen der Transportrichtung, erfolgen kann. Letzteres kann darüber hinaus auch bei einer Vorrichtung für den rein einspurigen Betrieb oder bei einer jedenfalls für den einspurigen Betrieb konfigurierbaren Vorrichtung vorgesehen sein.

Es folgt ein Schritt S2, bei dem die frisch gedruckte Antennenstruktur S1a im Hinblick auf potentielle Fertigungsfehler, insbesondere Druckfehler, automatisch, insbesondere mittels Bildauswertung, sensorisch inspiziert wird (Inspektionstest). In einem weiteren Schritt S3 erfolgt eine Verzweigung des Verfahrensablaufs in Abhängigkeit davon, ob bei dem Inspektionstest ein Fertigungsfehler erkannt wurde oder aber der Inspektionstest bestanden wurde. Im Fehlerfall (S3 - nein) springt das Verfahren unter Auslassung weiterer, für den fehlerfreien Fall vorgesehener, Fertigungsschritte S4 bis S9 direkt zu einem Vereinzelungsschritt S10, bei dem eine Vereinzelung der Antennenstruktur 1a mittels eines entsprechenden Zuschnitts des Trägersubstrats 2 erfolgt. Da der Inspektionstest nicht bestanden wurde, wird im nachfolgenden Schritt S11 zu einem Ausschleusungsschritt S13 verzweigt (S11- nein), bei dem die fehlerhafte Antennenstruktur 1a als Ausschuss aus dem Prozess ausgeschleust wird. Wird dagegen der Inspektionstest beim Schritt S2 bestanden (S3 - ja) folgt ein Trocknungsschritt S4, bei dem die gedruckte Antennenstruktur 1a auf eine unterhalb der Sintertemperatur der Tinte liegende Temperatur erwärmt wird, um die Tinte und/oder das Trägersubstrat teilweise, aber noch nicht vollständig, zu trocknen, so dass sich eine teilgetrocknete Antennenstruktur 1b ergibt.

Sodann wird in einem Schritt S5 ein elektronisches Bauelement 3, beispielsweise ein RFID Chip, so auf die teilgetrocknete Antennenstruktur 1b aufgebracht, dass sich dabei eine Berührungsfläche zwischen einem Anschlussbereich der Antennenstruktur 1b und einem entsprechenden elektrischen Anschluss des Bauelements 3, insbesondere einem Anschlusspad auf dem Chip ausbildet. Der Chip wird dabei typischerweise als sogenannter Nacktchip (Bare Die) aufgebracht, so dass sich eine nun bereits bestückte Antennenstruktur 1c ergibt. Sodann wird in einem weiteren Schritt S6 die Tinte im Bereich der Berührungsfläche zur vorläufigen klebstofflosen mechanischen Verbindung (Fixierung) des Bauelements 3 mit der Antennenstruktur 1c auf eine unterhalb der Sintertemperatur der Tinte liegende Temperatur erwärmt. Dieser Schritt S6 kann insbesondere auch, zumindest im Wesentlichen, gleichzeitig mit dem Schritt S5 erfolgen. Beim Schritt S6 wird die Fixierung insbesondere mittels weiteren Trocknens der Tinte erreicht, sodass sich eine Haftung zwischen dem aufgebrachten Bauelement 3 und der Antennenstruktur 1c ergibt, die insbesondere einen Schutz gegen eine unerwünschte Verschiebung des Bauelements relativ zum Antennenstruktur während des weiteren Verfahrensverlauf bis zur endgültigen Fixierung des Bauelements 3 an der Antennenstruktur liefert.

In einem weiteren Schritt S7 erfolgt nun ein Erwärmen der Antennenstruktur 1c zum Sintern derselben auf eine Sintertemperatur bei gleichzeitiger dadurch bewirkter Ausbildung, insbesondere Verstärkung, einer klebstofflose mechanischen und elektrischen Verbindung zwischen dem Anschlussbereich der Antennenstruktur 1c und dem elektrischen Anschluss des Bauelements 3. Durch das Sintern werden die Materialeigenschaften der Antennenstruktur 1c verändert. Insbesondere werden die metallischen Nanopartikel dabei so miteinander verbacken, dass sich bei der gesinterten Antennenstruktur 1d eine für die gewünschte Antennenfunktion erforderliche ausreichend hohe elektrische Leitfähigkeit ergibt. Des Weiteren wird die mechanische Verbindung bzw. Haftung des Bauelements an Antennenstruktur 1d dadurch ebenso noch verstärkt.

Es folgt ein Schritt S8, bei dem das elektronische Bauelement 3 mittels kontaktlosem Aufbringen einer Gehäusemasse (z. B. Globe Top) und Aushärten derselben mittels UV-Bestrahlung mit einem Gehäuse 4 versehen wird (Einhäusung). Die somit fertig gestellte Antennenstruktur/Bauelemente-Kombination 1e wird sodann in einem Schritt S9 getestet, insbesondere auf korrekte Funktion und/oder sonstige Defektfreiheit. Es folgt der schon erwähnte Vereinzelungsschritt S10 zur Vereinzelung der Antennenstruktur/Bauelement-Kombination 1e, soweit diese zunächst zusammen mit anderen auf einem gemeinsamen Trägersubstrat hergestellt wurde. Wird bei dem Test aus Schritt S9 ein Fehler festgestellt, (S11 - nein), so wird wieder zum bereits beschriebenen Schritt S13 verzweigt und die fehlerhafte Antennenstruktur/Bauelement-Kombination ausgeschleust. Andernfalls, wenn der Test erfolgreich bestanden wurde (S11- ja) wird die nun fertiggestellte fehlerfreie Antennenstruktur/Bauelement-Kombination 1f in einem Ausgabeschritt S12 als fehlerfreies Produkt ausgegeben. Der Einsatz des Vereinzelungsschritts kann insbesondere auch nur optional, insbesondere in Abhängigkeit von dem verwendeten Format des Trägersubstrats vorgesehen sein. So kann etwa im Falle eines bandförmigen Trägersubstrats entweder der Vereinzelungsschritt verwendet werden oder alternativ das Trägersubstrat einschließlich seiner fehlerfreien bestückten Antennenstrukturen sowie gegebenenfalls seiner fehlerbehafteten Antennenstrukturen mit oder ohne Bestückung aufgerollt werden.

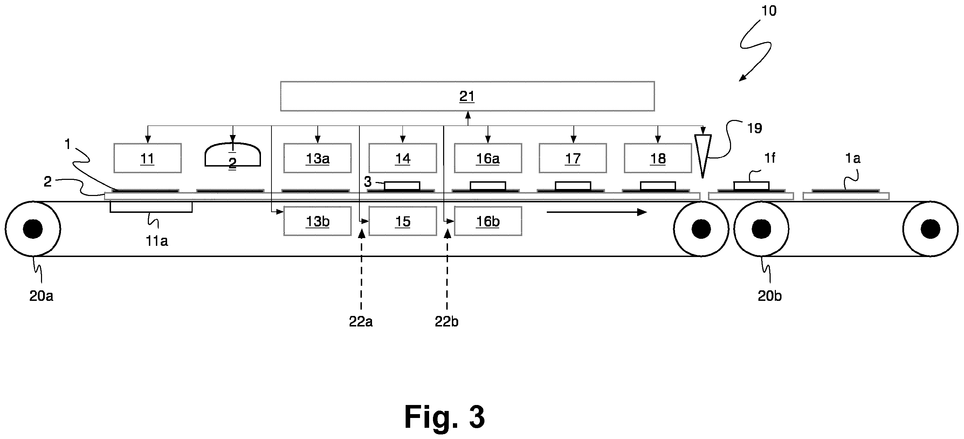

**Fig. 3** zeigt eine bevorzugte Ausführungsform der erfindungsgemäßen Vorrichtung 10, die insbesondere eingesetzt werden kann, um das Verfahren aus den Figuren 1 und 2 auszuführen. Im gezeigten Beispiel ist das Trägersubstrat 2 als Band ausgeführt, auf dem eine Mehrzahl von jeweils mit einem elektronischen Bauelement 3 bestückte Antennenstrukturen 1 hergestellt werden sollen. Das Band 2 wird dazu mittels einer Transportvorrichtung 20a in Form eines Förderbandes durch die Vorrichtung 10 transportiert (in der Figur 3 von links nach rechts).

Die Vorrichtung 10 weist eine Druckeinrichtung 11 auf, die insbesondere eingerichtet ist, den Schritt S1 auszuführen (vergleiche nachfolgend bezüglich der hier genannten Schritte jeweils Fig. 1 und - soweit relevant - Fig. 2). Ihr räumlich gegenüber ist eine Auflage 11a zur Stützung des Trägersubstrats 2 während des Druckvorgangs vorgesehen. Flussabwärts entlang der Transportrichtung des Trägersubstrats 2 folgt eine Sensoreinrichtung 12 mit einer Kamera zur visuellen Inspektion der mittels der Druckeinrichtung 11 frisch gedruckten Antennenstrukturen 1 auf den Trägersubstrat 2 (Schritt S2). Es folgt eine zweiteilige Trockeneinrichtung 13a, 13b, die das Trägersubstrat 2 mit der darauf gedruckten Antennenstruktur 1 beidseitig erwärmt, um sie teilweise zu trocknen (Schritt S4). Eine Bestückungseinrichtung 14 ist vorgesehen, um die Antennenstruktur 1 mit einem elektronischen Bauelement 3 mittels Aufbringen desselben zu bestücken (Schritt S5). Optional kann zusätzlich, insbesondere an gleicher Stelle, eine Fixierungseinrichtung 15 vorgesehen sein, die dazu dient, die Tinte bei bereits aufgebrachten Bauelement 3 weiter zu trocknen, um so eine vorläufige Fixierung des Bauelements 3 an der Antennenstruktur 1 zu bewirken (Schritt S6). Die Fixierungseinrichtung 15 kann insbesondere unterhalb der Bestückposition bzw. Bestückungseinrichtung angeordnet sein. Speziell im Falle einer Bestückung im DDA-Verfahren kann die Fixierungseinrichtung 15 optional zusammen mit der DDA-Bestückungseinrichtung 14 als integriertes separates Maschinenmodul ausgebildet sein, das mittels Puffereinrichtungen 22a, b in die Vorrichtung 10 eingebunden ist.

Es folgt entlang der Transportrichtung eine Sintereinrichtung 16a, 16b, mit Heizelementen, die beidseitig des Trägersubstrats 2 zur Erwärmung der bereits bestückten Antennenstruktur auf eine Sintertemperatur der Tinte zum Zwecke der Sinterung der Antennenstruktur 1 vorgesehen sind (Schritt S7). Flussabwärts davon folgt eine Einhäusungseinrichtung 17, die insbesondere dazu eingerichtet ist, eine geeignete Gehäusemasse in flüssiger oder pastösen Form kontaktlos, d.h. ohne dass ein mechanischer Kontakt zwischen der Einhäusungseinrichtung 17 und dem Bauelement 3 auftritt, auf das Bauelement 3 aufzubringen und dort, insbesondere mittels UV-Bestrahlung, auszuhärten (Schritt S8).

Zusätzlich oder alternativ zum Einhäusen des elektronischen Bauelements kann die bestückte Antennenstruktur vor oder besser nach der Sintereinrichtung 16a/16b mittels einer Beschichtungseinrichtung (nicht gezeigt) mit einem UV-härtenden Lack z.B. in einer Dicke von 10-50 µm beschichtet werden, z.B. durch Drucken, Vergießen oder Aufsprühen. Die Tinte muss dabei nicht zwingend ein Antioxidans enthalten, Der Lack bietet für die Antennenstruktur Schutz vor mechanischen Beschädigungen.

Flussabwärts von der Einhäusungseinrichtung 17 ist eine Prüfeinrichtung 18 angeordnet, die dazu dient, die bereits fertiggestellte Antennenstruktur/Bauelement-Kombination zu testen, insbesondere im Hinblick auf optisch erkennbare Beschädigungen oder Defekte und/oder ihre Funktionstüchtigkeit (Schritt S9). Schließlich folgt eine Vereinzelungseinrichtung 19, die eingerichtet ist, einzelne Antennenstruktur/Bauelement-Kombinationen 1f, die insbesondere als Funketiketten ausgelegt sein können, von dem bandförmigen Trägersubstrat 2 abzutrennen (Schritt S10).

Zur Steuerung der gesamten Anlage ist eine Steuerungseinrichtung 21 vorgesehen. Sie ist insbesondere eingerichtet, im Zusammenspiel mit der Sensoreinrichtung 12, wenn durch diese ein Defekt einer frisch gedruckten Antennenstruktur 1a erkannt wird (Schritt S3 - nein), eine weitere Prozessierung dieser defekten Antennenstruktur 1a an den Einrichtungen 13a, b bis 18 zu verhindern, und die defekte Antennenstruktur 1a als Ausschuss auszuschleusen (Schritt S13). Ebenso ist sie eingerichtet, die fertig gestellte Antennenstruktur/Bauelemente-Kombination 1f in Abhängigkeit vom Ergebnis der Prüfung (Schritt S11) durch die Prüfeinrichtung 18, entweder als fehlerfreies Produkt auszugeben (Schritt S12), oder andernfalls als Ausschuss auszuschleusen (Schritt S13). Die Steuerungseinrichtung 21 kann insbesondere ein Eingabemittel und einen Bildschirm aufweisen. Über eine Eingabemaske auf dem Bildschirm kann der Bediener auswählen, in welchen Umgebungsbedingungen die Antennenstruktur 1 eingesetzt werden soll, welche Tintenart vorliegt, welche Kenngröße/n (Größe der Antenne, Impedanz, Lesereichweite, Resonanzfrequenz, etc.) die Antennenstruktur 1 haben soll, oder welche Antennen-Geometrien mit einer vorhandenen Menge an Tinte gedruckt werden können, um möglichst viele Antennenstrukturen 1 drucken zu können. Durch Eingeben einer oder mehrerer Parameter werden dem Bediener passende Antennenstrukturen 1 errechnet und vorgeschlagen. Außerdem können die Druckeinrichtung 11, die Transportvorrichtungen 20a, b, die Trockeneinrichtung 13a,b, die Fixierungseinrichtung 15 und die Sintereinrichtung 16a, b jeweils durch die Steuerung an die ausgewählte Antennenstruktur 1 angepasst werden, z.B. indem die Transportgeschwindigkeit bei großer Auftragsdicke der Tinte deshalb für eine längere Sinterdauer reduziert wird. Dies kann vorteilhaft dazu eingesetzt werden, eine höhere Automatisierung, eine Effizienzerhöhung, geringere Stillstandzeiten um die Maschine einzustellen, und eine Reduktion von Ausschuss, der entsteht bis die Vorrichtun10 per Hand korrekt eingestellt ist, zu erreichen.

Optional können schließlich noch ein oder mehrere Puffereinrichtungen bzw. Pufferbereiche 22a, 22b vorgesehen sein, in denen das jeweilige Zwischenprodukt für einen vorbestimmten Zeitraum oder eine vorbestimmte Transportstrecke ohne weitere Prozesssicherung "gepuffert" wird, bevor sie dem nächsten Prozessschritt zugeführt wird. Dies kann insbesondere nach dem Trocknen in der Trockeneinrichtung 13a, b oder nach dem Bestücken bzw. Fixieren an der Bestückungseinrichtung 14 bzw. der Fixierungseinrichtung 15 sinnvoll sein, um dem jeweiligen Zwischenprodukt ausreichend Zeit für eine Nachwirkung des vorausgehenden Prozessschritts (insbesondere zur Trocknung der Tinte und oder des dadurch befeuchteten Trägersubstrats) zu geben.

Während vorausgehend wenigstens eine beispielhafte Ausführungsform beschrieben wurde, ist zu bemerken, dass eine große Anzahl von Variationen dazu existiert. Es ist dabei auch zu beachten, dass die beschriebenen beispielhaften Ausführungsformen nur nichtlimitierende Beispiele darstellen, und es nicht beabsichtigt ist, dadurch den Umfang, die Anwendbarkeit oder die Konfiguration der hier beschriebenen Vorrichtungen und Verfahren zu beschränken. Vielmehr wird die vorausgehende Beschreibung dem Fachmann eine Anleitung zu Implementierung mindestens einer beispielhaften Ausführungsform liefern, wobei sich versteht, dass verschiedene Änderungen in der Funktionsweise und der Anordnung der in einer beispielhaften Ausführungsform beschriebenen Elemente vorgenommen werden können, ohne dass dabei von dem in den angehängten Ansprüchen jeweils festgelegten Gegenstand sowie seinen rechtlichen Äquivalenten abgewichen wird.

### BEZUGSZEICHENLISTE

- 1: Antennenstruktur
- 1a: frisch gedruckte Antennenstruktur mit noch nicht getrockneter Tinte
- 1b: Antennenstruktur nach dem ersten (Teil-)Trocknungsschritt
- 1c: mit elektronischem Bauteil bestückte Antennenstruktur
- 1d: gesinterte und bestückte Antennenstruktur
- 1e: Antennenstruktur mit eingehäustem Bauelement
- 1f: vereinzelte Antennenstruktur mit eingehäustem Bauelement
- 2: Trägersubstrat
- 3: elektronisches Bauelement, insbesondere Chip mit integrierter Schaltung
- 4: Gehäuse des Bauelements, insbesondere Globe Top

- 10: Vorrichtung zum Bestücken von Antennenstrukturen mit Bauelementen
- 11: Druckeinrichtung
- 11a: Auflage zur Stützung des Trägersubstrats
- 12: Sensoreinrichtung, insbesondere Kamera
- 13a, b: Trockeneinrichtung
- 14: Bestückungseinrichtung
- 15: Fixierungseinrichtung
- 16a, b: Sintereinrichtung
- 17: Einhäusungseinrichtung
- 18: Prüfeinrichtung
- 19: Vereinzelungseinrichtung
- 20a, b: Transporteinrichtungen
- 21: Steuereinrichtung
- 22a, b: Pufferbereiche bzw. Puffereinrichtungen

## Patentansprüche

1. Verfahren zur Bestückung einer Antennenstruktur (1), insbesondere einer RFID-Antennenstruktur, mit einem elektronischen Bauelement (3), insbesondere einem RFID-Chip, wobei das Verfahren aufweist:
Erzeugen der Antennenstruktur (1, 1a), vor dem Aufbringen des Bauelements (3), mittels Aufdrucken der Antennenstruktur (1, 1a) auf das Trägersubstrat (2) mittels einem sinterfähigen und nach seiner Sinterung elektrisch leitfähigen Material, wobei das sinterfähige Material eine sinterfähige Tinte ist, welche elektrisch leitfähige Partikel zur Ausbildung einer elektrischen Leitfähigkeit der durch das nachfolgende Erwärmen gesinterten Antennenstruktur (1, 1d) enthält;
Aufbringen eines elektronischen Bauelements (3) auf die auf einem Trägersubstrat (2) ausgebildete Antennenstruktur (1; 1a, 1b) aus dem sinterfähigen und nach seiner Sinterung elektrisch leitfähigen Material, so dass sich dabei eine Berührungsfläche zwischen einem Anschlussbereich der Antennenstruktur (1) und einem entsprechenden elektrischen Anschluss des Bauelements (3) ausbildet;
Erwärmen der Antennenstruktur (1) zum Sintern derselben bei gleichzeitiger dadurch bewirkter Ausbildung einer klebstofflosen mechanischen und elektrischen Verbindung zwischen dem Anschlussbereich der Antennenstruktur (1) und dem elektrischen Anschluss des Bauelements (3);
wobei das Verfahren des Weiteren den folgenden Heizschritt aufweist:
Erwärmen des sinterfähigen Materials im Bereich der Berührungsfläche auf eine unterhalb der Sintertemperatur des sinterfähigen Materials liegende Temperatur zur vorläufigen klebstofflosen mechanischen Verbindung des Bauelements (3) mit der Antennenstruktur (1, 1c).

2. Verfahren nach Anspruch 1, des Weiteren aufweisend:
vor dem Aufbringen des Bauelements (3), Erwärmen der ausgebildeten Antennenstruktur (1, 1a) auf eine unterhalb der Sintertemperatur des sinterfähigen Materials liegende Temperatur zur zumindest teilweisen Trocknung des sinterfähigen Materials und/oder des Trägersubstrats (2).

3. Verfahren nach einem der vorausgehenden Ansprüche, wobei die Tinte des Weiteren ein Antioxidansmittel enthält.

4. Verfahren nach einem der vorausgehenden Ansprüche, wobei das Aufdrucken der Antennenstruktur (1, 1a) auf das Trägersubstrat (2) mittels eines Tintenstrahldruckers erfolgt.

5. Verfahren nach einem der vorausgehenden Ansprüche, wobei beim Erwärmen der Antennenstruktur (1, 1c) zum Sintern derselben die Antennenstruktur (1, 1c) zumindest im Bereich der Berührungsfläche auf eine Temperatur von mindestens 250 °C, bevorzugt von mindestens 300 °C erhitzt wird.

6. Verfahren nach einem der vorausgehenden Ansprüche, wobei das Aufbringen des Bauelements (3) auf die Antennenstruktur (1, 1b), erfolgt durch:
unmittelbares Übertragen des Bauelements (3) von einem Bauteilträgersubstrat auf die Antennenstruktur (1, 1b); oder
mittelbares Übertragen des Bauelements (3) von einem Bauteilträgersubstrat auf die Antennenstruktur (1, 1b) mittels einer Übertragungseinrichtung, die das Bauelement (3) von dem Bauteilträgersubstrat übernimmt, zur Antennenstruktur (1, 1b) transportiert, und auf diese aufbringt.

7. Verfahren nach einem der vorausgehenden Ansprüche, des Weiteren aufweisend:
Einhäusen des elektronischen Bauelements (3) nach Herstellung von dessen mechanischer und elektrischer Verbindung mit der Antennenstruktur (1, 1d).

8. Verfahren nach Anspruch 6, wobei das Einhäusen kontaktlos mittels Aufbringen einer flüssigen oder pastösen Gehäusemasse auf das Bauteil (3) und anschließendes Aushärten derselben erfolgt.

9. Verfahren nach einem der vorausgehenden Ansprüche, des Weiteren aufweisend:
sensorisches Inspizieren der Antennenstruktur (1) und/oder des Bauteils (3) zu zumindest einem Zeitpunkt während des Ablaufs des Verfahrens; und
Steuern des Weiteren Verfahrensablaufs in Abhängigkeit von Ergebnis dieser sensorischen Inspektion.

10. Verfahren nach Anspruch 9, wobei, wenn gemäß dem Ergebnis der Inspektion ein Produktionsfehler erkannt wurde, der weitere Verfahrensverlauf so gesteuert wird, dass dabei zumindest ein Verfahrensschritt des Verfahrens, der zur Herstellung einer fehlerfreien Antennenstruktur-Bauelement-Kombination (1, 3 bzw. 1f) verfahrensgemäß vorgesehen ist, ausgelassen wird.

11. Verfahren nach einem der vorausgehenden Ansprüche, wobei:
das Trägersubstrat (2) bandförmig ausgebildet ist und entlang seiner Längsrichtung transportiert wird; und
entlang einer zu der Längsrichtung in einem Winkel verlaufenden zweiten Richtung auf dem Trägersubstrat eine Mehrzahl von Antennenstrukturen (1) vorgesehen sind bzw. erzeugt werden, so dass sich entlang der Transportrichtung ein mehrspuriger Herstellungsprozess zur Herstellung einer entsprechend auf mehreren Spuren verteilten Menge an Antennenstruktur/Bauteil-Kombinationen (1, 3 bzw. 1f) ergibt.

12. Vorrichtung (10) zur Bestückung einer Antennenstruktur (1, 1a), insbesondere einer RFID Antennenstruktur, mit einem elektronischen Bauelement (3), insbesondere einem RFID-Chip, wobei die Vorrichtung (10) eingerichtet ist, das Verfahren gemäß einem der vorausgehenden Ansprüche auszuführen.

13. Vorrichtung nach Anspruch 12; aufweisend:
eine Bestückungseinrichtung (14), die konfiguriert ist, ein elektronisches Bauelement (3) auf eine auf einem Trägersubstrat (2) ausgebildete Antennenstruktur (1, 1b) aus einem sinterfähigen und nach seiner Sinterung elektrisch leitfähigen Material so aufzubringen, dass sich dabei eine Berührungsfläche zwischen einem Anschlussbereich der Antennenstruktur (1, 1c) und einem entsprechenden elektrischen Anschluss des Bauelements (3) ausbildet;
eine Sintereinrichtung (16a, b), die konfiguriert ist, die Antennenstruktur zum Sintern derselben bei gleichzeitiger dadurch bewirkter Ausbildung einer klebstofflosen mechanischen und elektrischen Verbindung zwischen dem Anschlussbereich der Antennenstruktur (1, 1c) und dem elektrischen Anschluss des Bauelements (3) zu erwärmen.

14. Vorrichtung nach Anspruch 13, wobei die Bestückungseinrichtung (14) aufweist:
eine erste Übertragungseinrichtung, die konfiguriert ist zum unmittelbaren Übertragen eines Bauelements von einem Trägersubstrat (2) auf die Antennenstruktur (1, 1b); und/oder
eine zweite Übertragungseinrichtung, die konfiguriert ist zum mittelbaren Übertragen eines Bauelements (3) von einem Trägersubstrat (2) auf die Antennenstruktur (1, 1b), wobei die zweite Übertragungseinrichtung konfiguriert ist, das Bauelement (3) von einem Trägersubstrat (2) zu übernehmen, zur Antennenstruktur (1, 1b) zu transportieren, und es auf diese aufzubringen.

15. Vorrichtung nach einem der Ansprüche 12 bis 14, des Weiteren aufweisend eine oder mehrere der folgenden Einrichtungen:
Eine Druckeinrichtung (11), die konfiguriert ist zum Erzeugen der Antennenstruktur (1, 1a), vor dem Aufbringen des Bauelements (3), mittels Aufdrucken der Antennenstruktur (1, 1a) auf das Trägersubstrat (2) mittels einer sinterfähigen Tinte, welche elektrisch leitfähige Partikel zur Ausbildung einer elektrischen Leitfähigkeit der Antennenstruktur (1, 1d) durch Sintern mittels der Sintereinrichtung (16a, b) enthält.
Eine Trockeneinrichtung (13a, b), die konfiguriert ist zum Erwärmen der erzeugten Antennenstruktur (1, 1a) auf eine unterhalb der Sintertemperatur des Materials der Antennenstruktur (1, 1a) liegenden Temperatur zur zumindest teilweisen Trocknung der Tinte und/oder des Trägersubstrats (2) vor dem Aufbringen des Bauelements (3);
Eine Fixierungseinrichtung (15), die konfiguriert ist, die Tinte im Bereich der Berührungsfläche auf eine unterhalb der Sintertemperatur der Tinte liegende Temperatur zur vorläufigen klebstofflosen mechanischen Verbindung des Bauelements (3) mit der Antennenstruktur (1, 1a)zu erwärmen;
Eine Einhäusungseinrichtung (17), die konfiguriert ist zum Einhäusen des elektronischen Bauelements (3) nach Herstellung von dessen mechanischer und elektrischer Verbindung mit der Antennenstruktur (1, 1c);
Eine Sensoreinrichtung (12) zum sensorischen Inspizieren der Antennenstruktur und/oder des Bauteils zu zumindest einem Zeitpunkt während des Ablaufs des Verfahrens, sowie eine Steuerungseinrichtung (21) zum Steuern des Weiteren Verfahrensablaufs in Abhängigkeit von Ergebnis dieser sensorischen Inspektion;
Eine Puffereinrichtung (22a, b), die konfiguriert ist zum Puffern des Trägersubstrats (2) zwischen zwei aufeinanderfolgenden der Einrichtungen (11 bis 19) der Vorrichtung (10);
Eine Prüfeinrichtung (18) zum Testen der fertiggestellten Antennenstruktur/Bauteil-Kombination (1, 3 bzw. 1e);
Eine Vereinzelungseinrichtung (19) zum Vereinzeln der auf einem gemeinsamen Trägersubstrat (2) hergestellten Antennenstruktur/Bauelement-Kombinationen (1, 3 bzw. 1e).

## Claims

1. A method for the equipping of an antenna structure (1), in particular an RFID antenna structure, with an electronic component (3), in particular with an RFID chip, wherein the method comprises:
producing the antenna structure (1, 1a), prior to the application of the component (3), by printing the antenna structure (1, 1a) on the carrier substrate (2) by means of a sinterable material that is electrically conductive after its sintering, wherein the sinterable material is a sinterable ink which contains electrically conductive particles in order to form an electrical conductivity of the antenna structure (1, 1d), which is sintered by the subsequent heating;
applying of an electronic component (3) to the antenna structure (1; 1a, 1b) which is formed on a carrier substrate (2) and which is made from the sinterable material that is electrically conductive after its sintering, so that a contact surface is formed between a contact region of the antenna structure (1) and a corresponding electrical contact of the component (3);
heating the antenna structure (1) in order to sinter the same, and, caused thereby, with simultaneous formation of an adhesive-free mechanical and electrical connection between the contact region of the antenna structure (1) and the electrical contact of the component (3);
heating the sinterable material in the region of the contact surface to a temperature which is below the sintering temperature of the sinterable material for preliminary adhesive-free mechanical connection of the component (3) with the antenna structure (1, 1c).

2. The method according to claim 1, further comprising:
prior to the application of the component (3), heating the antenna structure formed (1, 1a) to a temperature which is below the sintering temperature of the sinterable material in order to at least partially dry the sinterable material and / or the carrier substrate (2).

3. The method according to any one of the preceding claims, wherein the ink further contains an antioxidant.

4. The method according to any one of the preceding claims, wherein the printing of the antenna structure (1, 1a) onto the carrier substrate (2) is carried out by means of an inkjet printer.

5. The method according to any one of the preceding claims, wherein, during heating of the antenna structure (1, 1c) for sintering of the same, the antenna structure (1, 1c) is heated to a temperature of at least 250 °C, preferably at least 300 °C, at least in the region of the contact surface.

6. The method according to any one of the preceding claims, wherein the application of the component (3) to the antenna structure (1, 1b) is carried out by:
direct transfer of the component (3) from a component carrier substrate to the antenna structure (1, 1b); or
indirect transfer of the component (3) from a component carrier substrate to the antenna structure (1, 1b) by means of a transfer device, which takes the component (3) from the component carrier substrate, transports it to the antenna structure (1, 1b) and applies it to the antenna structure (1, 1b).

7. The method according to any one of the preceding claims, further comprising:
encapsulating the electronic component (3) after making its mechanical and electrical connection to the antenna structure (1, 1d).

8. The method according to claim 6, wherein the encapsulating is carried out in a contactless manner by means of the application of a liquid or paste-like encapsulation compound onto the component (3) and subsequent curing thereof.

9. The method according to any one of the preceding claims, further comprising:
a sensor-based inspection of the antenna structure (1) and / or of the component (3) at at least one point in time during the course of the method; and
controlling of the further course of the method in dependence upon the result of this sensor-based inspection.

10. The method according to claim 9, wherein, if a production fault has been detected according to the result of the inspection, the further course of the method is controlled in such a way that at least one method step of the method which is envisaged for the manufacture of a fault-free antenna structure / component combination (1, 3 or 1f) according to the method is omitted.

11. The method according to any one of the preceding claims, wherein:
the carrier substrate (2) is constructed so as to be in the form of a tape and is transported along its longitudinal direction; and
a plurality of antenna structures (1) are provided or generated on the carrier substrate along a second direction which runs at an angle to the longitudinal direction, so that a multi-track manufacturing process for manufacturing a quantity of antenna structure / component combinations (1, 3 or 1f) which are distributed accordingly over several tracks results along the transport direction.

12. An apparatus (10) for equipping an antenna structure (1, 1a), in particular an RFID antenna structure, with an electronic component (3), in particular an RFID chip, wherein the apparatus (10) is arranged to carry out the method according to any one of the preceding claims.

13. The apparatus according to claim 12; comprising:
an equipping device (14) which is configured to place an electronic component (3) on an antenna structure (1, 1b) which is formed on a carrier substrate (2), which antenna structure (1, 1b) is made of a sinterable material that is electrically conductive after its sintering, in such a way that a contact surface is formed between a contact region of the antenna structure (1, 1c) and a corresponding electrical contact of the component (3);
a sintering device (16a, b) which is configured to heat the antenna structure in order to sinter it while thereby simultaneously causing an adhesive-free mechanical and electrical connection to be formed between the contact region of the antenna structure (1, 1c) and the electrical contact of the component (3).

14. The apparatus according to claim 13, wherein the equipping device (14) comprises:
a first transfer device which is configured in order to directly transfer a component from a carrier substrate (2) to the antenna structure (1, 1b); and / or
a second transfer device which is configured in order to indirectly transfer a component (3) from a carrier substrate (2) to the antenna structure (1, 1b), wherein the second transfer device is configured to take the component (3) from a carrier substrate (2), to transport it to the antenna structure (1, 1b), and to apply it to the antenna structure (1, 1b).

15. The apparatus according to any one of the claims 12 to 14, further comprising one or more of the following devices:
a printing device (11) which is configured to generate the antenna structure (1, 1a), prior to the application of the component (3), by printing the antenna structure (1, 1a) onto the carrier substrate (2) by means of a sinterable ink which contains electrically conductive particles, in order to form an electrical conductivity of the antenna structure (1, 1d) by sintering by means of the sintering device (16a, b);
a drying device (13a, b) which is configured to heat the antenna structure (1, 1a) which has been generated, to a temperature which is below the sintering temperature of the material of the antenna structure (1, 1a) for at least partial drying of the ink and / or of the carrier substrate (2) prior to the application of the component (3);
a fixing device (15) which is configured to heat the ink in the region of the contact surface to a temperature which is below the sintering temperature of the ink for preliminary adhesive-free mechanical connection of the component (3) to the antenna structure (1, 1a);
an encapsulating device (17) which is configured to encapsulate the electronic component (3) after its mechanical and electrical connection to the antenna structure (1, 1c) has been established;
a sensor device (12) for the sensor-based inspection of the antenna structure and / or of the component at at least one point in time during the course of the method, as well as a control device (21) for controlling the further course of the method as a function of the result of this sensor-based inspection;
a buffer device (22a, b) which is configured to buffer the carrier substrate (2) between two successive ones of the devices (11 to 19) of the apparatus (10);
a testing device (18) for testing the completed antenna structure / component combination (1, 3 or 1e);
a separating device (19) for separating the antenna structure / component combinations (1, 3 or 1e) which have been produced on a common carrier substrate (2).

## Revendications

1. Procédé de montage d'une structure d'antenne (1), en particulier d'une structure d'antenne RFID, avec un composant électronique (3), en particulier une puce RFID, dans lequel le procédé présente :
la génération de la structure d'antenne (1, 1a), avant l'application du composant (3), au moyen de l'impression de la structure d'antenne (1, 1a) sur le substrat porteur (2) au moyen d'un matériau pouvant être fritté et électroconducteur après son frittage, dans lequel le matériau pouvant être fritté est une encre pouvant être frittée qui contient des particules électroconductrices pour la réalisation d'une conductibilité électrique de la structure d'antenne (1, 1d) frittée par le chauffage suivant ;
l'application d'un composant électronique (3) sur la structure d'antenne (1 ; 1a, 1b) réalisée sur un substrat porteur (2) à partir du matériau pouvant être fritté et électroconducteur après son frittage de sorte qu'une surface de contact se réalise entre une zone de raccordement de la structure d'antenne (1) et un raccordement électrique correspondant du composant (3) ;
le chauffage de la structure d'antenne (1) pour le frittage de cette dernière en cas de réalisation simultanée provoquée ainsi d'une liaison électrique et mécanique sans colle entre la zone de raccordement de la structure d'antenne (1) et le raccordement électrique du composant (3) ;
dans lequel le procédé présente en outre l'étape de chauffage suivante :
le chauffage du matériau pouvant être fritté dans la zone de la surface de contact à une température se trouvant en dessous de la température de frittage du matériau pouvant être fritté pour la liaison mécanique sans colle temporaire du composant (3) avec la structure d'antenne (1, 1c).

2. Procédé selon la revendication 1, présentant en outre :
avant l'application du composant (3), le chauffage de la structure d'antenne (1, 1a) réalisée à une température se trouvant en dessous de la température de frittage du matériau pouvant être fritté pour le séchage au moins partiel du matériau pouvant être fritté et/ou du substrat porteur (2).

3. Procédé selon l'une quelconque des revendications précédentes, dans lequel l'encre contient en outre un antioxydant.

4. Procédé selon l'une quelconque des revendications précédentes, dans lequel l'impression de la structure d'antenne (1, 1a) sur le substrat porteur (2) est effectuée au moyen d'une imprimante à jet d'encre.

5. Procédé selon l'une quelconque des revendications précédentes, dans lequel lors du chauffage de la structure d'antenne (1, 1c) pour son frittage la structure d'antenne (1, 1c) est chauffée au moins dans la zone de la surface de contact à une température d'au moins 250 °C, de préférence d'au moins 300 °C.

6. Procédé selon l'une quelconque des revendications précédentes, dans lequel l'application du composant (3) sur la structure d'antenne (1, 1b) est effectuée par :
la transmission directe du composant (3) d'un substrat porteur de composant à la structure d'antenne (1, 1b) ; ou
la transmission indirecte du composant (3) d'un substrat porteur de composant à la structure d'antenne (1, 1b) au moyen d'un dispositif de transmission qui prend le composant (3) du substrat porteur de composant, le transporte vers la structure d'antenne (1, 1b), l'applique sur celle-ci.

7. Procédé selon l'une quelconque des revendications précédentes, présentant en outre :
le logement du composant électronique (3) après l'établissement de sa liaison mécanique et électrique avec la structure d'antenne (1, 1d).

8. Procédé selon la revendication 6, dans lequel le logement est effectué sans contact au moyen de l'application d'une masse de boîtier liquide ou pâteuse sur le composant (3) et ensuite son durcissement.

9. Procédé selon l'une quelconque des revendications précédentes, présentant en outre :
l'inspection sensorielle de la structure d'antenne (1) et/ou du composant (3) à au moins un moment pendant le déroulement du procédé ; et
la commande en outre du déroulement du procédé en fonction du résultat de cette inspection sensorielle.

10. Procédé selon la revendication 9, dans lequel, lorsque selon le résultat de l'inspection une erreur de production a été reconnue, la suite du déroulement du procédé est commandée de sorte qu'au moins une étape du procédé qui est prévue pour la fabrication d'une combinaison de structure d'antenne-composant (1, 3 ou 1f) sans erreur selon le procédé, soit omise.

11. Procédé selon l'une quelconque des revendications précédentes, dans lequel :
le substrat porteur (2) est réalisé en forme de bande et est transporté le long de son sens longitudinal ; et
le long d'une seconde direction s'étendant dans un angle par rapport au sens longitudinal sur le substrat porteur une pluralité de structures d'antenne (1) sont prévues ou générées de sorte qu'il résulte le long du sens de transport un processus de fabrication à plusieurs voies pour la fabrication d'une quantité répartie sur plusieurs voies de manière correspondante de combinaisons de structure d'antennecomposant (1, 3 ou 1f).

12. Dispositif (10) pour le montage d'une structure d'antenne (1, 1a), en particulier d'une structure d'antenne RFID, avec un composant électronique (3), en particulier une puce RFID, dans lequel le dispositif (10) est conçu afin de réaliser le procédé selon l'une quelconque des revendications précédentes.

13. Dispositif selon la revendication 12 ; présentant :
un dispositif de montage (14) qui est configuré afin d'appliquer un composant électronique (3) sur une structure d'antenne (1, 1b) réalisée sur un substrat porteur (2) en un matériau pouvant être fritté et électroconducteur après son frittage de sorte qu'une surface de contact se réalise entre une zone de raccordement de la structure d'antenne (1, 1c) et un raccordement électrique correspondant du composant (3) ;
un dispositif de frittage (16a, b) qui est configuré afin de chauffer la structure d'antenne pour son frittage en cas de réalisation simultanée provoquée ainsi d'une liaison électrique et mécanique sans colle entre la zone de raccordement de la structure d'antenne (1, 1c) et le raccordement électrique du composant (3).

14. Dispositif selon la revendication 13, dans lequel le dispositif de montage (14) présente :
un premier dispositif de transmission qui est configuré pour la transmission directe d'un composant d'un substrat porteur (2) à la structure d'antenne (1, 1b) ; et/ou
un second dispositif de transmission qui est configuré pour la transmission indirecte d'un composant (3) d'un substrat porteur (2) à la structure d'antenne (1, 1b), dans lequel le second dispositif de transmission est configuré afin de prendre le composant (3) d'un substrat porteur (2), de le transporter vers la structure d'antenne (1, 1b), et de l'appliquer sur celle-ci.

15. Dispositif selon l'une quelconque des revendications 12 à 14, présentant en outre un ou plusieurs des dispositifs suivants :
un dispositif d'impression (11) qui est configuré pour la génération de la structure d'antenne (1, 1a) avant l'application du composant (3), au moyen de l'impression de la structure d'antenne (1, 1a) sur le substrat porteur (2) au moyen d'une encre pouvant être frittée qui contient des particules électroconductrices pour la réalisation d'une conductibilité électrique de la structure d'antenne (1, 1d) par le frittage au moyen du dispositif de frittage (16a, b) ;
un dispositif de séchage (13a, b) qui est configuré pour le chauffage de la structure d'antenne (1, 1a) générée à une température se trouvant en dessous de la température de frittage du matériau de la structure d'antenne (1, 1a) pour le séchage au moins partiel de l'encre et/ou du substrat porteur (2) avant l'application du composant (3) ;
un dispositif de fixation (15) qui est configuré afin de chauffer l'encre dans la zone de la surface de contact à une température se trouvant en dessous de la température de frittage de l'encre pour la liaison mécanique sans colle temporaire du composant (3) avec la structure d'antenne (1, 1a) ;
un dispositif de logement (17) qui est configuré pour le logement du composant électronique (3) après l'établissement de sa liaison mécanique et électrique avec la structure d'antenne (1 1c) ;
un dispositif capteur (12) pour l'inspection sensorielle de la structure d'antenne et/ou du composant à au moins un moment pendant le déroulement du procédé, ainsi qu'un dispositif de commande (21) pour la commande de la suite du déroulement du procédé en fonction du résultat de cette inspection sensorielle ;
un dispositif tampon (22a, b) qui est configuré pour la mise en tampon du substrat porteur (2) entre deux consécutifs des dispositifs (11 à 19) du dispositif (10) ;
un dispositif de vérification (18) pour le test de la combinaison de structure d'antenne/composant (1, 3 ou 1e) achevée ;
un dispositif de séparation (19) pour la séparation des combinaisons de structure d'antenne-composant (1, 3 ou 1e) fabriquées sur un substrat porteur (2) commun.
